# EUROPEAN PATENT APPLICATION

(11) **EP 2 532 470 A1**
(43) Date of publication of application: **12.12.2012**
(21) Application number: 11739701.8
(22) Date of filing: 31.01.2011
(51) Int. Cl.: B23K 26/40, B23K 26/38

(54) **FORMATION METHOD FOR MICROSTRUCTURE, AND SUBSTRATE HAVING MICROSTRUCTURE**

(30) Priority: 05.02.2010 JP 2010024775
(71) Applicant: FUJIKURA LTD., Kohtoh-ku Tokyo 135-8512 (JP); Bio Electro-mechanical Autonomous Nano Systems Laboratory Technology Research Association, Tokyo 101-0026 (JP); The University of Tokyo, Bunkyo-Ku Tokyo 113-8654 (JP)
(72) Inventor: NUKAGA, Osamu, Sakura-shi Chiba 285-8550 (JP); SAMUKAWA, Seiji, Tokyo 101-0026 (JP); SUGIYAMA, Masakazu, Tokyo 113-8654 (JP)
(74) Representative: Cabinet Plasseraud
(86) International application number: PCT/JP2011/051891
(87) International publication number: WO 2011/096353

(57) **Abstract**

A nanostructure forming method includes: preparing a substrate having an appropriate processing value; applying laser light having a pulse duraiton of picosecond order or less to a planar surface oriented in a propagation direction of the laser light and a direction perpendicular to a polarization direction (electric field direction) of the laser light in the interior of the substrate at an irradiation intensity which is close to the appropriate processing value of the substrate; forming a structure-modified portion at a focus at which the laser light is concentrated and in a region which is close to the focus; and forming a nanostructure formed of a nano-hole by selectively etching the structure-modified portion.

## Description

### TECHNICAL FIELD

The present invention relates to a nanostructure forming method using an ultrashort pulse laser irradiation and etching, and a base having a nanostructure.
Priority is claimed on Japanese Patent Application No. 2010-024775, filed February 5, 2010, the content of which is incorporated herein by reference.

### BACKGROUND ART

As a method of forming a nanostructure on a substrate (processing material), the following methods are known.
As a first method, a nanostructure forming method using a photolithography technique is known. In this method, first, a mask is formed on the surface of a material, and then a nanostructure is formed using wet etching or dry etching (for example, see the following Patent Document 1).

As a second method, a method is known in which laser beam having a pulse duration of picosecond order or shorter is concentrated and applied to form a structure-modified portion on the light-concentrated portion, and then wet etching using a hydrofluoric acid is performed to form a trench or a micro-hole having a high aspect ratio, or a branch or a branched and bent structure in a horizontal direction or the like (for example, see the following Patent Document 2).

As a third method, the following method is known.

First, a laser pulse having a pulse duration of picosecond order or shorter is concentrated and applied to the surface of a processing material and part which is close to the surface, or the interior of the processing material, so that a modified portion and periodic nanostructures perpendicular to the laser polarization are formed on the light-concentrated portion or focus due to the interference between incident light and the electron plasma wave generated by the laser pulse.

Otherwise, a circularly polarized wave is concentrated and applied to the interior of a processing material to form a unique structure eddying in a rotation direction of the polarized wave (for example, see the following Patent Document 3).

Next, polishing is performed to expose a laser-modified portion, and by wet etching using a hydrofluoric acid, the periodic nanostructures are selectively etched and a periodic uneven nanostructures are formed (for example, see the following Non-Patent Document 1).

As a fourth method, a method is proposed in which the surface of a substrate is covered with water or ethanol, laser light having a pulse duration of picosecond order or shorter is concentrated and applied, and ablation is carried out on the light-concentrated portion or focus to form a micro hole (for example, see the following Non-Patent Document 2).

However, in the above-described first photolithography, generally, a structure having a high aspect ratio with a several nano-order width and a depth of five microns or less is not easily formed on a processing material such as silica glass.

In addition, since the processing form is limited to a one-dimensional direction, etching in a horizontal direction is not easily performed in the interior of the processing material.

In addition, in the second described method with a combination of the pulsed laser and the wet etching, etching in a horizontal direction and a vertical direction is possible. However, a micron-order hole having a hole diameter of at least several microns or greater is mainly processed, and a nano-order processing width is not easily realized.

Furthermore, in the third described method, several periodic nanostructures can be formed. However, the periodic nanostructures are formed in a self-assembled manner. Accordingly, it is difficult to simply form a hole at an arbitrary location, and no etching method in a horizontal direction is reported.

In addition, when processing is carried out using the fourth method, micro-hole processing in a horizontal direction and a vertical direction is possible. However, due to the following reasons, that is, (1) the processing is micron-order processing in which a hole diameter is at least several microns or greater, (2) processing by ablation is carried out, whereby the processed surface is rough, (3) the processing speed is low, and (4) when the aspect is large, clogging with particles scattering due to the ablation occurs, and thus there are problems such as interruption of etching.

### PRIOR ART DOCUMENTS

### PATENT DOCUMENTS

[Patent Document 1] Japanese Unexamined Patent Application, First Publication No. 2006-111525
[Patent Document 2] Japanese Unexamined Patent Application, First Publication No. 2005-219105
[Patent Document 3] Japanese Unexamined Patent Application, First Publication No. 2004-035255

### NON-PATENT DOCUMENTS

[Non-Patent Document 1] OPTICS LETTERS/July 15, 2005/vol. 30, NO. 14/1867.
[Non-Patent Document 2] Applied Physics A/August, 2005/vol. 79, NO. 3/605.

### DISCLOSURE OF INVENTION

### PROBLEMS TO BE SOLVED BY INVENTION

The invention was devised in view of such conventional circumstances, and a first object of the invention is to provide a nanostructure forming method in which it is possible to control a processing form and it is possible to form a nanostructure having a nano-order opening width with a high aspect ratio.
In addition, a second object of the invention is to provide a base which is provided with a nanostructure having a nano-order opening width with a high aspect ratio.

### MEANS FOR SOLVING THE PROBLEMS

A nanostructure forming method according to an aspect of the invention includes: preparing a substrate having an appropriate processing value; applying laser light having a pulse duration of picosecond order or shorter to a planar surface oriented in a propagation direction of the laser light and a direction perpendicular to a polarization direction (electric field direction) of the laser light in the interior of the substrate at an irradiation intensity which is close to the appropriate processing value of the substrate; forming a structure-modified portion at a focus at which the laser light is concentrated and in a region which is close to the focus (first process); and forming a nanostructure formed of a nano-hole by selectively etching the structure-modified portion (second process).

The nanostructure may be a trench.

The nanostructure may be a via hole.

At least part of the nanostructure may form a bent or branched structure in the interior of the substrate, or a three-dimensional structure arranged parallel to or oblique to a surface of the substrate.

Periodic nanostructures which are formed perpendicularly to the polarization direction of the laser may be formed in a self-assembled manner on the surface of the substrate.

A base according to an aspect of the invention has a nanostructure which is formed in the interior of a substrate using the above-described nanostructure forming method.

### EFFECTS OF THE INVENTION

In a nanostructure forming method according to an aspect of the invention, in the first process, laser light is applied to the interior of a substrate, and a structure-modified portion is formed in a region in which the laser light is concentrated and a region which is close to the focus. Thereafter, in the second process, the structure-modified portion is selectively etched to form a nanostructure formed of a nano-hole.

At this time, in the first process, the irradiation intensity of the laser light is set to be close to an appropriate processing value of the substrate, and the region irradiated with the laser light is in a planar surface oriented in a propagation direction of the laser light and a direction perpendicular to a polarization direction of the laser light. Thus, one structure-modified portion is formed by laser irradiation without the formation of periodic nanostructures.

Then, by performing etching, a nanostructure formed of a nano-hole having a nano-order opening width and a high aspect ratio is formed. As a result, according to the aspects of the invention, it is possible to provide a nanostructure forming method in which the processing form can be controlled and a nanostructure having at least a nano-order opening width in the polarization direction of the laser light and a high aspect ratio can be formed.

In addition, a base of the invention has a nanostructure formed of a nano-hole in the interior of a substrate. Since the nano-hole is formed using the above-described nanostructure forming method of the invention, it has a high aspect ratio.

As a result, according to the aspects of the invention, it is possible to provide a base which is provided with a nanostructure having a nano-order opening width with a high aspect ratio.

### BRIEF DESCRIPTION OF THE DRAWINGS

FIG. 1 is a perspective view schematically showing a nanostructure forming method according to an embodiment of the invention.
FIG. 2 is a perspective view schematically showing the nanostructure forming method according to the embodiment of the invention.
FIG. 3A schematically shows a relationship between a laser irradiation energy and a formed structure-modified portion (single stripelike region with low oxygen concentration).
FIG. 3B schematically shows a relationship between a laser irradiation energy and a formed structure-modified portion (stripelike regions with low oxygen concentration).
FIG. 4 is a photograph showing an example of formation of a nanostructure formed of a nano-hole.
FIG. 5 is a photograph showing another example of formation of a nanostructure formed of a nano-hole.
FIG. 6 is a perspective view schematically showing an example of the configuration of a base of the invention.
FIG. 7 is a cross-sectional view of a nano-hole formed using a conventional technique.
FIG. 8 is a cross-sectional view of a nano-hole formed using the invention.

### EMBODIMENTS FOR CARRYING OUT THE INVENTION

Hereinafter, preferred embodiments of a nanostructure forming method and a base according to an embodiment of the invention will be described.

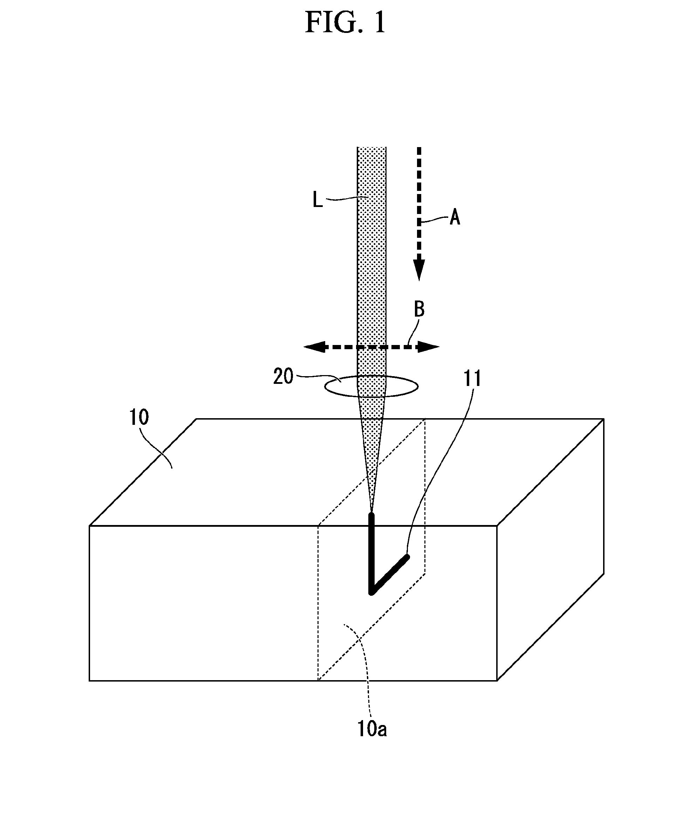

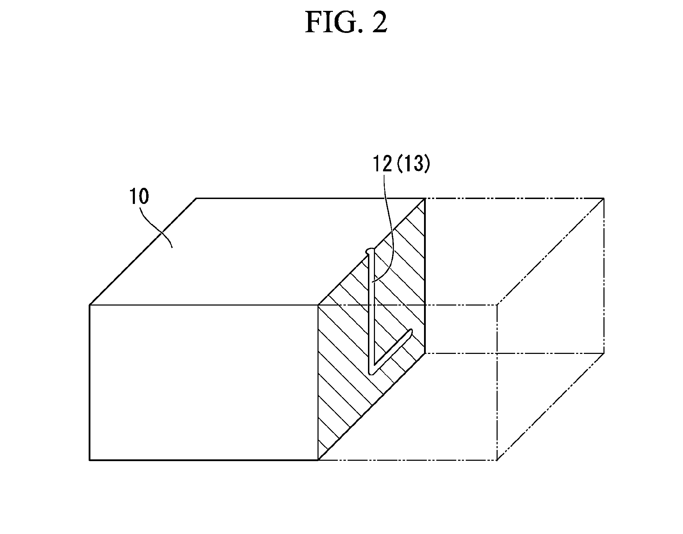

FIGS. 1 and 2 are perspective view schematically showing a nanostructure forming method of this embodiment.

The nanostructure forming method of this embodiment has a first process (see FIG. 1) of irradiating the interior of a substrate 10 with laser light L to form a structure-modified portion 11 at a focus at which the laser light L is concentrated and in a region which is close to the focus; and a second process (see FIG. 2) of selectively etching the structure-modified portion 11 to form a nanostructure 13 formed of a nano-hole 12, and in the first process, the irradiation intensity of the laser light L is set to be close to an appropriate processing value of the substrate 10, and the region irradiated with the laser light L is in a planar surface 10a oriented in a propagation direction of the laser light L (the arrow A in FIG. 1) and a direction perpendicular to a polarization (also referred to as an electric field, or an electric field vector) direction of the laser light L (the arrow B in FIG. 1).

In the fine structure forming method of this embodiment, in the first process, the interior of the substrate 10 is irradiated with laser light L to form the structure-modified portion 11 at a focus at which the laser light L is concentrated and in a region which is close to the focus, and then in the second process, the structure-modified portion 11 is selectively etched to form the nanostructure 13 formed of the nano- hole 12.
At this time, in the first process, since the irradiation intensity of the laser light L is set to be close to an appropriate processing value of the substrate 10, and the region irradiated with the laser light L is in the planar surface 10a oriented in the propagation direction of the laser light L (the arrow A) and the direction perpendicular to the polarization direction of the laser light L (the arrow B), one structure-modified portion 11 is formed by laser irradiation without the formation of periodic nanostructures.
Then, by performing etching, the nano-hole 12 having a nano-order opening width and a high aspect ratio is formed.
As a result, in the nanostructure forming method of this embodiment, the processing form can be controlled, and the nanostructure 13 having at least a nano-order opening width in the polarization direction of the laser light and a high aspect ratio can be formed.

Hereinafter, the processing will be described in order.

(1) As shown in FIG. 1, the interior of the substrate 10 is irradiated with laser light L to form the structure-modified portion 11 at the focus at which the laser light L is concentrated and in the region which is close to the focus (first process).
   First, laser light L is concentrated and applied to the interior of the substrate 10 using a lens 20, or applied while the light-concentrated portion is being scanned, thereby forming the structure-modified portion 11.
   At this time, the irradiation intensity of the laser light L is set to be close to an appropriate processing value of the substrate 10, and the polarization direction of the laser is set to be perpendicular to the scanning direction.
   Here, the appropriate processing value is defined as a minimum value of the laser pulse energy for forming self- assembled periodic nanostructures.

As a material of the substrate 10, it is preferable to use a material which has high transmittance with respect to the wavelength of the laser.
Synthetic silica having the highest processability and other materials, for example, glass materials such as borosilicate glass and crystalline materials such as silica, sapphire, diamond, and silicon single crystal can be used.

In addition, as the laser light L, it is preferable to use laser light having a pulse duration of picosecond order or shorter.
For example, a Ti-sapphire laser, a fiber laser, and the like can be used.
However, it is necessary to use a wavelength which is transparent with respect to the substrate 10.

As the lens 20 which concentrates the laser light L, for example, a refractive objective lens or a refractive lens can be used.
For example, Fresnel, reflective, oil immersion, and water immersion lenses can also be used for irradiation. In addition, for example, when using a cylindrical lens, it is possible to perform laser irradiation over a wide range of the surface of the substrate 10 at one time.
In addition, for example, when using a conical lens, it is possible to perform irradiation with the laser light L over a wide range in a direction perpendicular to the substrate 10 at one time.
However, when using a cylindrical lens, it is necessary for the polarization of the laser light L to be parallel to a direction in which the lens 20 has a curvature.

In addition, in this embodiment, the region irradiated with the laser light L is in the planar surface 10a oriented in the propagation direction of the laser light L (the arrow A) and the direction perpendicular to the polarization direction of the laser light L (the arrow B).
As for the polarization, detailed description has been given regarding a linearly polarized wave, but the same structure is formed even with a laser pulse having some elliptically polarized wave components.
In addition, description has been given regarding the region irradiated with the laser light L using the relationship between the propagation direction of the laser light L (the arrow A) and the polarization direction of the laser light L (the arrow B), but even when there is a little angular variation from the perpendicularity, the same structure is obtained.
That is, the angle between the planar surface 10a and the polarization direction of the laser light L (the arrow B) is preferably greater than 88° to 90°, more preferably 88.5° to 90°, even more preferably 89° to 90°, and particularly preferably 90°.

The method of applying laser light L is not particularly limited. However, a structure which can be formed with single continuous irradiation is limited to a one-dimensional direction perpendicular to the polarization direction and a two-dimensional direction of the propagation direction of the laser light L.
That is, a structure which is formed with single continuous irradiation is formed in the planar surface 10a oriented in the propagation direction of the laser light L (the arrow A) and the direction perpendicular to the polarization direction of the laser light L (the arrow B).
In the two-dimensional direction, the structure can be formed arbitrarily in the interior of the substrate 10.
For example, irradiation can be performed so that the irradiated portion overlaps in a direction parallel to the propagation direction of the laser light L, processing can be performed in a direction perpendicular to or oblique to the propagation direction of the laser light L, or a branched structure, a curve, or the like can be formed in the planar surface 10a in the interior of the substrate 10.
At this time, it is desirable that a position which is the most distant in the propagation direction of the laser light L be first irradiated and the next close position be irradiated.
When a close position is first irradiated and the next distant position is irradiated, a structure-modified portion formed at the close position inhibits the propagation of the laser light L, whereby a structure-modified portion may not be easily formed at the distant position.

In order to form a structure extending in a three-dimensional direction, it is necessary to change the polarization direction in the formation.
The surface which can be processed with single drawing is a surface oriented in the propagation direction of the laser light L and the direction perpendicular to the polarization direction.
When processing a planar surface at a different angle, a three-dimensionally complicated structure can also be formed by changing the polarization direction.
When a plurality of planar surfaces are processed, the processing can be performed by changing the position at which the laser light L is concentrated and the polarization direction of the laser light L.
Furthermore, when a plurality of structure-modified portions formed in a surface which can be processed with once drawing are adjacent to or intersect with each other, the nano-holes can be connected to each other by performing an etching treatment.

Specifically, for example, a Ti-sapphire laser (laser using a crystal as a laser medium in which sapphire is doped with titanium) is used.
As irradiation conditions, for example, the laser light L is concentrated and applied at a wavelength of 800 nm with a repetition frequency of 200 kHz and a laser scanning speed of 1 mm/sec.
The values of the wavelength, the repetition frequency, and the scanning speed are an example, and the invention is not limited thereto, and can be arbitrarily changed.

When the Ti-sapphire laser is applied to a silica substrate, it is preferable to use an objective lens having an N.A. less than 0.7 as the lens 20 which is used for light concentration.
In irradiating a part which is close to the surface of a silica substrate with laser light, the pulse energy is preferably close to the appropriate processing value (for example, approximately 80 nJ/pulse or less).
When the pulse energy is greater than or equal to the appropriate processing value, a nano-order processing width is not easily processed, and a micron-order processing width is obtained.
Otherwise, a structure with a plurality of periodic structures is formed, and the structure of the invention cannot be formed.
Furthermore, even when the N.A. is greater than or equal to 0.7, the structure-modified portion can be formed, but the spot size is reduced, the laser fluence per pulse in the light-concentrated portion increases, and a structure with a plurality of periodic structures may be formed.
Accordingly, when using an objective lens having an N.A. greater than or equal to 0.7, it is necessary to further reduce the pulse energy of the laser light in the light-concentrated portion.

In addition, in the invention, the single nanostructure is formed perpendicularly to the polarization direction of the laser light L in a self-assembled manner.
When a part which is close to the surface of the substrate 10 is processed under similar laser irradiation conditions and etching conditions, a several periodic uneven nanostructures are formed in a direction perpendicular to the polarization direction of the laser light L on the surface of the substrate 10, and then, the periodicity of the several periodic uneven nanostructures is along the polarization direction of the laser light L.
Accordingly, when processing a part which is close to the surface of the substrate 10 and the interior of the substrate 10 under the same conditions, a periodic structure can be formed in the part which is close to the surface of the substrate 10 simultaneously with the formation of the nanostructure 13 having at least a nano-order opening width in the polarization direction in the interior of the substrate 10.
Also, description has been given regarding a case in which the polarized wave is a linearly polarized wave, but even when a laser pulse having some elliptically polarized wave components is used, the same periodic structure is formed.

(2) Next, as shown in FIG. 2, the structure-modified portion 11 is selectively etched to form the nanostructure 13 formed of the nano-hole 12 (second process).
Thereafter, by performing etching, the structure-modified portion 11 is selectively etched and the nanostructure 13 formed of the nano-hole 12 is formed.
Accordingly, the nanostructure 13 having at least a nano-order opening width in the electric field vector direction can be formed.
Regarding this nano-hole 12 (nanostructure 13), a processing form having a complicated structure which is oriented in a horizontal direction and has a branch, bending, and the like can also be internally realized, and even when the nano-hole 12 has a structure having a high aspect ratio, etching stop does not occur.

It is known that by concentrating and applying a pulsed laser having a pulse duration of picosecond order or shorter at an irradiation intensity which is greater than or equal to an appropriate processing value, interference occurs between the electron plasma waves and the incident light in the light-concentrated portion, and the periodic nanostructures perpendicular to the polarization of the laser are formed in a self-assembled manner.
The periodic nanostructures are regarded as a region having low etching resistance.
For example, in the case of silica, regions with low oxygen concentration and regions with high oxygen concentration are periodically arranged, the etching resistance of an low oxygen concentration portion (the above-described periodic structure) is weakened, and periodic valleys and fins are formed when performing etching.

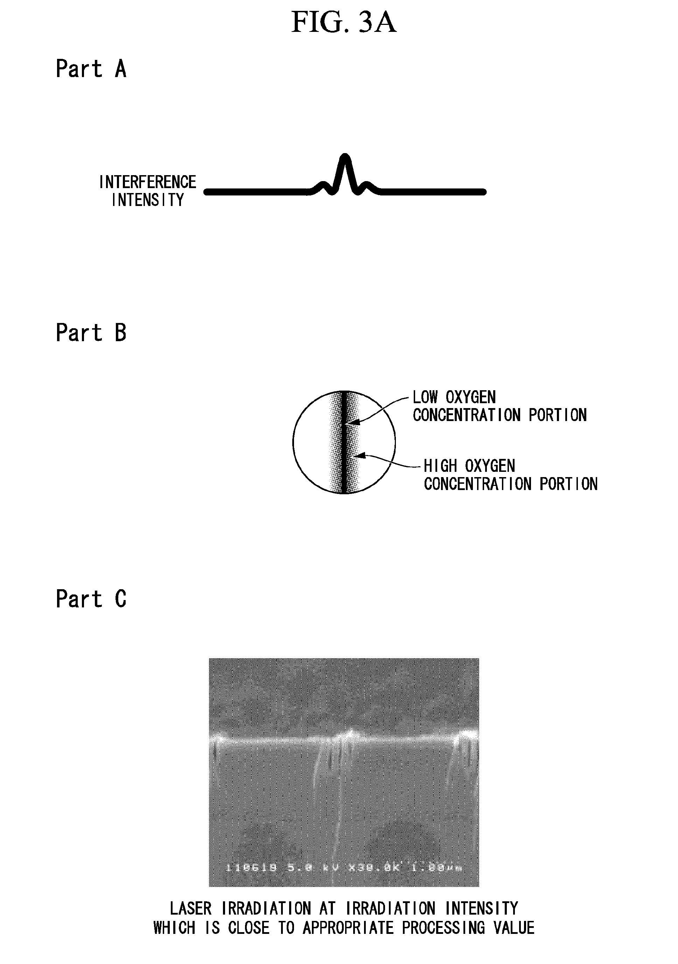

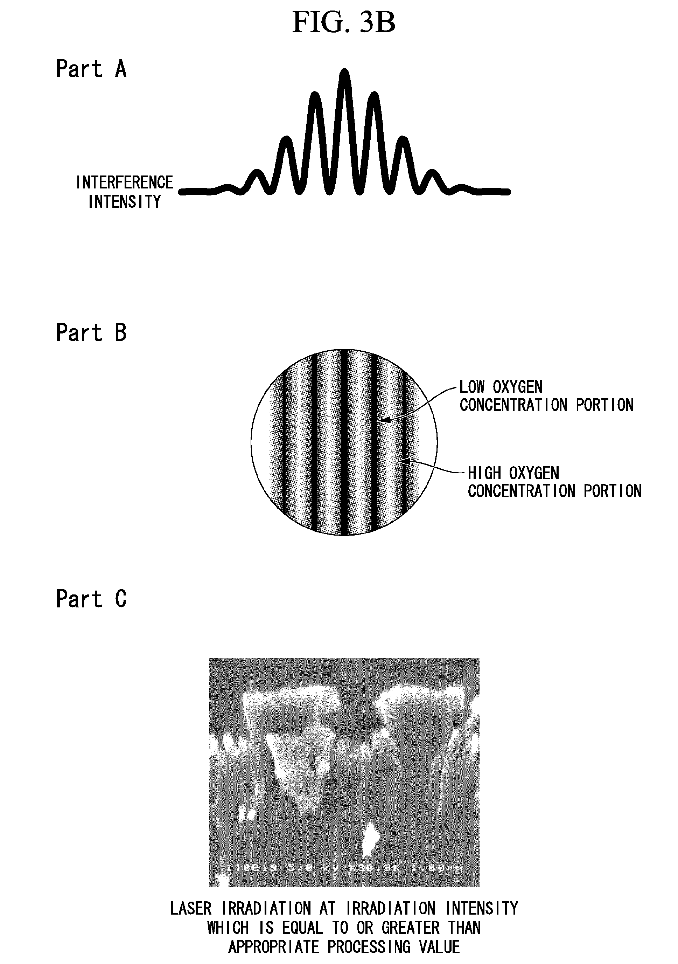

As shown in FIG. 3A, when performing laser irradiation (Part A in FIG. 3A) in the interior of the substrate 10 at an irradiation intensity which is close to the appropriate processing value, particularly, at an irradiation intensity which is less than the appropriate processing value and greater than or equal to a minimum value (threshold) of the laser irradiation energy by which the substrate 10 can be modified and the etching resistance can thus be reduced, one low oxygen concentration portion (Part B in FIG. 3A) is formed by laser irradiation without the formation of periodic nanostructures.
The photograph in Part C of FIG. 3A is a photograph of a cross-section of one low oxygen concentration portion formed in a silica substrate.
On the other hand, as shown in FIG. 3B, when a laser irradiation energy which is greater than or equal to the appropriate processing value is given, a plurality of low oxygen concentration portions are internally formed in a self-assembled manner.
The low oxygen concentration portion (structure-modified portion 11) is extremely easily etched when only one low oxygen concentration portion is formed by laser irradiation.
On the other hand, when a plurality of low oxygen concentration portions are present, the plurality of low oxygen concentration portions has an etching property inferior to that of one low oxygen concentration portion.
The inventors of the invention have discovered this fact for the first time.
Here, differences between a nano-hole which is formed of a plurality of low oxygen concentration portions in the conventional technique and the nano-hole in the invention will be described.

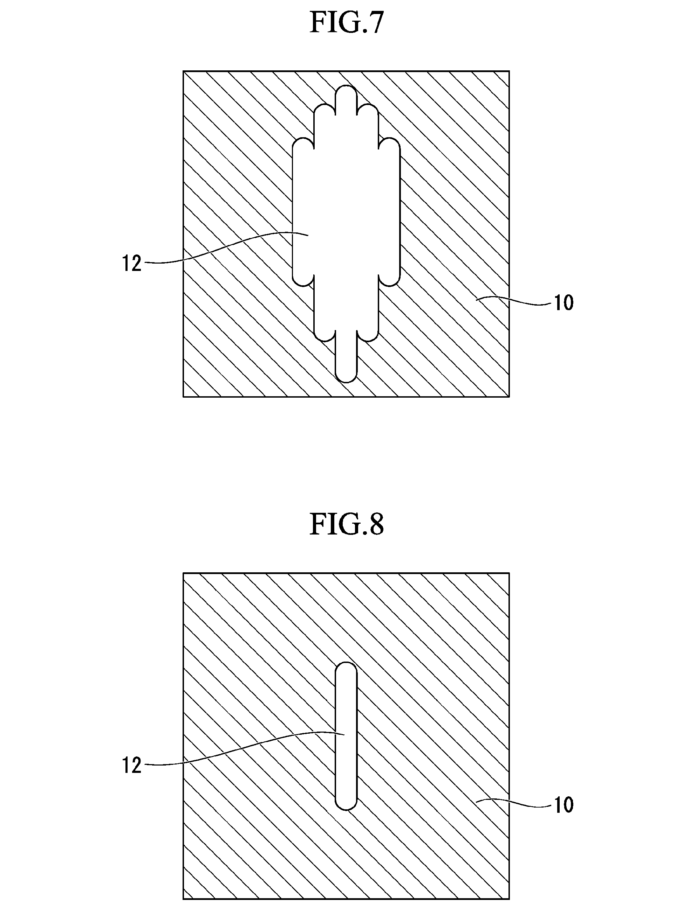

FIG. 7 shows the cross-section shape of a nano-hole in the conventional technique.
In the past, a plurality of low oxygen concentration portions have been formed in a self-assembled manner in the interior of a focus at which laser light is concentrated by giving a laser irradiation energy greater than or equal to the appropriate processing value. Next, when performing an etching treatment, the plurality of low oxygen concentration portions are selectively etched, and thus a plurality of nano-holes are formed.
Furthermore, when the etching treatment is continuously performed, a high oxygen concentration region which is present between nano-holes neighboring to each other is also etched, and the nano-holes neighboring to each other are joined to each other.
In this manner, one nano-hole is formed as shown in FIG. 7.
The nano-hole formed using the conventional technique has an uneven form, the outer edge of which is not smooth.
On the other hand, even under the conditions so that nano-holes neighboring to each other are not joined to each other, the plurality of nano-holes have different cross-section shapes and different sizes, whereby it is difficult to form a plurality of nano holes having a uniform form.
FIG. 8 shows a cross-section shape of the nano-hole of the invention.
Since laser irradiation is performed at an irradiation intensity which is close to the appropriate processing value, particularly, at an irradiation intensity which is less than the appropriate processing value and greater than or equal to a minimum value (threshold) of the laser irradiation energy by which the substrate 10 can be modified and the etching resistance can thus be reduced, one low oxygen concentration portion is formed without the formation of periodic structures at the focus.
Next, when performing an etching treatment, one nano-hole is formed and the cross-section shape is obtained as shown in FIG. 8.
The above nano-hole is different from the nano-hole formed in the conventional technique, and has a smooth outer edge.

As for the etching, wet etching or dry etching can be used.
In the wet etching, for example, it is most preferable to use 1 % or less of a hydrofluoric acid, but other acids and basic materials may be used.

As for an etching system which can be used in the dry etching, various dry etching systems such as barrel-type plasma etching, parallel plate-type plasma etching, and downflow-type chemical dry etching can be used as an isotropic etching method.

As an anisotropic dry etching method, for example, a method using reactive ion etching (hereinafter, RIE), such as parallel plate-type RIE, magnetron-type RIE, ICP-type RIE, and NLD-type RIE, can be used.
Other than RIE, for example, etching using a neutral beam can be used.
When using an anisotropic dry etching method, the mean free path of ions can be reduced by, for example, raising the process pressure to perform processing similar to isotropic etching.

As a gas to be used, a gas capable of chemically etching a material, such as fluorocarbon-based gases, SF-based gases, CHF3, fluorine gas, and chlorine gas, is mainly used, and appropriate other gases, oxygen, argon, helium, and the like can be mixed therewith and used. Processing using other dry etching systems can also be performed.

The nanostructure 13 formed of the nano-hole 12 arranged in the interior of the substrate 10 can be formed in the above-described manner.
Since the processed nanostructure 13 has a flat structure, the nano-order structure is present in at least only a one-dimensional polarization direction.
The opening width in the polarization direction is almost determined in accordance with an etching rate. Accordingly, processing to have an approximately several nano-order width is also possible in theory.

The nanostructure 13 formed of the nano-hole 12 formed in this manner is used to function as, for example, a trench or a via hole.
When the nanostructure 13 has a trench structure having a high aspect ratio, the surface area thereof increases.
Therefore, when a conductive or dielectric film is formed, a capacitor having a large capacitance can be formed.
In addition, by filling a via hole with a conductive material, wiring can be formed in the via hole.
Also, at least part thereof can be provided with a bent or branched structure in the interior of the substrate 10, or a three-dimensional structure arranged parallel to or oblique to the surface of the substrate 10, and substrates having various three-dimensional structures can be provided.

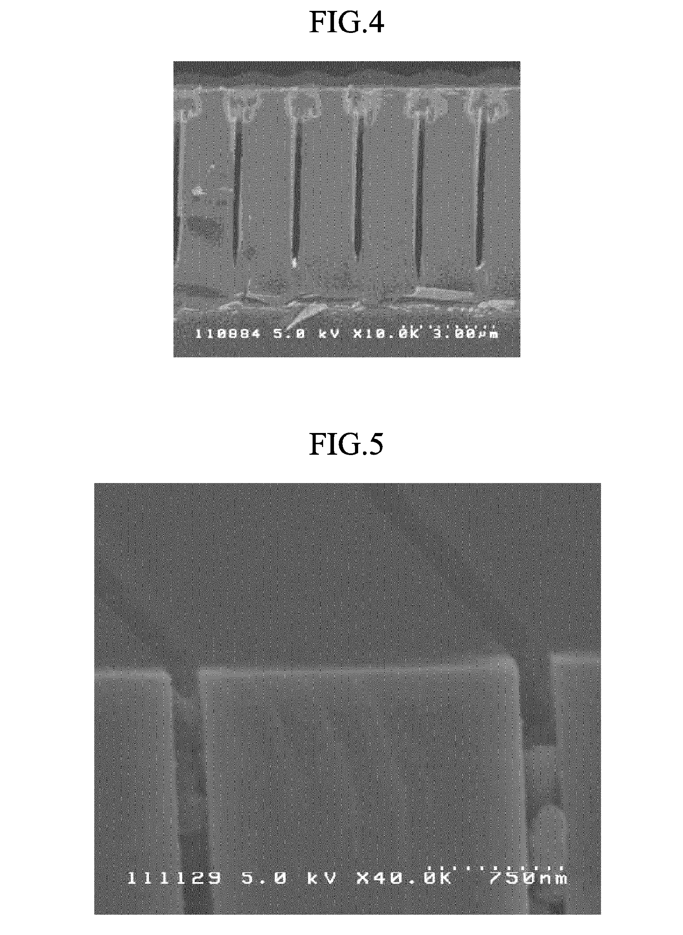

FIG. 4 shows an example of the nanostructure 13 formed using the above-described method of this embodiment.
The nanostructure 13 shown in FIG. 4 relates to a case in which the nano-hole 12 forms a trench.
In etching, 1% or less of a hydrofluoric acid is used to carry out the processing.
Since a part which is close to the surface has a different electron plasma wave distribution, it has periodic nanostructures having an increased processing width which is shown in the second method in Background Art, but a nano-order trench structure is formed therein.
The width of the trench is approximately 200 nm.
The depth of the trench is approximately 5 µm.
The reason for the trench depth of approximately 5 µm is that the laser irradiation was carried out only up to that depth.
Accordingly, when the laser irradiation is carried out in a deeper region, the depth of the trench can be made deeper.

In addition, the reason for the trench processing width of approximately 200 nm is that dependence on the etching using a hydrofluoric acid is large.
Therefore, a trench having a smaller width can be formed by reducing an etching concentration or etching time.
On the other hand, by increasing an etching amount, a micron- or higher-order processing width can also be realized.

In addition, when the surface of the substrate 10 is removed by polishing, a trench which does not include a structure having an increased processing width as shown in FIG. 4 can be formed.
Furthermore, when laser light is not directly concentrated on the surface, but laser irradiation is performed up to immediately below the surface, as shown in FIG. 5, a trench structure which does not include periodic structures can be formed on the surface of the substrate 10.
Accordingly, even when the surface is not polished, a trench which does not include periodic structures can also be formed on the surface of the substrate.

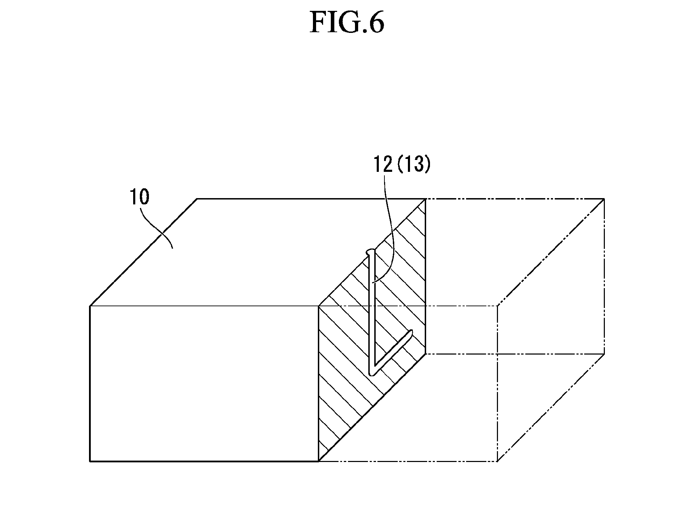

FIG. 6 is a cross-sectional view schematically showing an example of the configuration of a base 1 according to this embodiment.
The base 1 according to this embodiment has a nanostructure 13 formed of a nano-hole 12 in the interior of a substrate 10.
Since the nano-hole 12 is formed using the above-described method according to this embodiment, it has a high aspect ratio.
As a result, the base 1 according to this embodiment has a nano-order opening width, and the nanostructure 13 having a high aspect ratio is provided.
The base 1 which is provided with the nanostructure 13 formed of the nano-hole 12 having a high aspect ratio can be used in various devices.

In the above-described nanostructure forming method according to this embodiment, detailed description has been given using a case in which the irradiation intensity of the laser light is set to be close to the appropriate processing value of the substrate in the first process, but the irradiation intensity of the laser light may be outside the range as long as the effects of the invention can be obtained.
For example, the irradiation intensity of the laser light may be greater than or equal to the appropriate processing value of the substrate and less than or equal to an ablation threshold.
In addition, the nanostructure obtained using the above-described forming method according to this embodiment also includes, for example, a structure (for example, structure partially including a plurality of fine valleys and fins) which partially includes an uneven structure obtained by etching periodic nanostructures which is formed in a self-assembled manner by laser irradiation using a laser condition in which the irradiation intensity of the laser light is not close to the appropriate processing value of the substrate.

As described above, the nanostructure forming method and the base having the nanostructure according to the invention have been described, but the invention is not limited thereto, and can be appropriately changed without departing from the gist of the invention.

### INDUSTRIAL APPLICABILITY

A nanostructure forming method and a base having the nanostructure according to the invention can be widely applied to technique fields such as micro-fluidic channels, micro-wells, optical components, ICs, and electronic components.

### DESCRIPTION OF THE REFERENCE SYMBOLS

- 1:: BASE
- 10:: SUBSTRATE
- 10a:: PLANAR SURFACE
- 11:: STRUCTURE-MODIFIED PORTION
- 12:: NANO-HOLE
- 13:: NANOSTRUCTURE
- L:: LASER LIGHT

## Claims

1. A nanostructure forming method comprising:
preparing a substrate having an appropriate processing value;
applying laser light having a pulse duration of picosecond order or less to a planar surface oriented in a propagation direction of the laser light and a direction perpendicular to a polarization direction (electric field direction) of the laser light in the interior of the substrate at an irradiation intensity which is close to the appropriate processing value of the substrate;
forming a structure-modified portion at a focus at which the laser light is concentrated and in a region which is close to the focus; and
forming a nanostructure formed of a nano-hole by selectively etching the structure-modified portion.

2. The nanostructure forming method according to Claim 1, wherein
the nanostructure is a trench.

3. The nanostructure forming method according to Claim 1, wherein
the nanostructure is a via hole.

4. The nanostructure forming method according to Claim 1, wherein
at least part of the nanostructure forms a bent or branched structure in the interior of the substrate, or a three-dimensional structure arranged parallel to or oblique to a surface of the substrate.

5. The nanostructure forming method according to any one of Claims 1 to 4, wherein
periodic nanostructures which is formed perpendicularly to the polarization direction of the laser is formed in a self-assembled manner on the surface of the substrate.

6. A base comprising:
a nanostructure which is formed in the interior of a substrate using the method according to any one of Claims 1 to 5.
